(19) **Europäisches Patentamt / European Patent Office / Office européen des brevets**

(11) **EP 4 752 269 A1**

(12) **EUROPEAN PATENT APPLICATION**
published in accordance with Art. 153(4) EPC

(43) Date of publication:
03.06.2026   Bulletin 2026/23

(21) Application number: 24845539.6

(22) Date of filing: 19.07.2024

(51) International Patent Classification (IPC):
*C30B 29/04* (2006.01)    *C01B 32/28* (2017.01)
*C30B 33/04* (2006.01)

(52) Cooperative Patent Classification (CPC):
C01B 32/28; C30B 29/04; C30B 33/04

(86) International application number:
PCT/JP2024/025892

(87) International publication number:
WO 2025/023162 (30.01.2025 Gazette 2025/05)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority:   26.07.2023   JP 2023121832

(71) Applicants:
• Shin-Etsu Polymer Co., Ltd.
Tokyo 100-0004 (JP)
• SHIN-ETSU CHEMICAL CO., LTD.
Tokyo 100-0005 (JP)
• National University Corporation Saitama
University
Saitama City, Saitama 338-8570 (JP)

(72) Inventors:
• IKENO Junichi
Saitama-shi, Saitama 338-8570 (JP)
• YAMADA Yohei
Saitama-shi, Saitama 338-8570 (JP)
• SUZUKI Hideki
Saitama-shi, Saitama 331-0811 (JP)
• MATSUO Rika
Saitama-shi, Saitama 331-0811 (JP)
• NOGUCHI Hitoshi
Annaka-shi, Gunma 379-0195 (JP)

(74) Representative: **Berggren Oy**
P.O. Box 16
Fabianinkatu 21
00101 Helsinki (FI)

(54) **METHOD FOR PRODUCING DIAMOND SUBSTRATE**

(57)   A new diamond substrate having a {100} plane as a main surface is created from a single crystal diamond having a {100} plane as a main surface. The method includes a step of performing prior processing on a first starting point 42A and a second starting point 42b respectively set on a first crystal face 11a and a second crystal face 11b from among crystal faces constituting a {111} plane, by condensing the laser light using the laser condenser, the first crystal face 11a and the second crystal face 11b forming a wedge structure whose tip becomes thinner toward the main surface 10a inside a single crystal diamond block 10; and a step of forming a scanning line unit 14 by condensing the laser light using the laser condenser 190, and forming a first scanning line 41a and a second scanning line 41b on the first crystal face 11a and the second crystal face 11b, respectively, using processing marks from the first starting point 42a and the second starting point 42b toward the main surface 10a, the first scanning line 41a and the second scanning line 41b being connected at the tip of the wedge structure 12.

EP 4 752 269 A1

# FIG. 4

## EP 4 752 269 A1

### Description

TECHNICAL FIELD

The present invention relates to a method of manufacturing a diamond substrate, more specifically, to a method of manufacturing a diamond substrate by processing single crystal diamonds using laser light.

BACKGROUND ART

Conventionally, silicon carbide (SiC) and gallium nitride (GaN) have been provided as semiconductor materials suitable for power devices instead of silicon (Si). However, compared with conventional semiconductor materials, diamond is attracting attention as a next-generation semiconductor material due to higher breakdown electric field and power control index as well as the highest thermal conductivity, and research and development for practical application are in progress. Nitrogen-vacancy centers (NV centers) in diamond, enabling highly sensitive magnetic detection at room temperature, have been researched and are expected to be applied to magnetic sensors (see Patent Literature 1).

Single crystal diamond, which is expected to be applied to semiconductors, is synthesized by a high-temperature high-pressure method (HPHT method) or homoepitaxial growth, but these synthesis methods have difficulty in enlarging the area of a bulk substrate of single crystal diamond for use in semiconductor processes. Therefore, a vapor phase synthesis method (CVD method) that enables heteroepitaxial growth of single crystal diamond using single crystal magnesium oxide (MgO) as a base crystal, has been applied due to its superiority in enlarging the area.

A diamond substrate is manufactured by slicing a diamond single crystal ingot, or a block obtained by cutting the ingot to a predetermined length, to a fixed thickness with a wire saw using diamond as abrasive particles. The wire of the wire saw has a diameter of, for example, at least several tens of micrometers. Therefore, a width portion along a cut surface is lost as a processing allowance when a diamond single crystal ingot or a block is sliced into diamond substrates.

Further, a method of manufacturing a diamond substrate from a diamond ingot using laser light is disclosed (see Patent Literature 2). In this method, a modified layer having a modified crystal structure is formed by condensing and irradiating laser light to a predetermined depth from a main surface of the diamond ingot, and scanning the diamond ingot in two dimensions. A diamond substrate is stripped off from the modified layer.

CITATION LIST

PATENT LITERATURE

Patent Literature 1: Japanese Unexamined Patent Application Publication No. 2015-59069
Patent Literature 2: Japanese Unexamined Patent Application Publication No. 2020-50563

SUMMARY OF THE INVENTION

TECHNICAL PROBLEM

A diamond single crystal has a property that cleavage easily progresses along a {111} plane. When a diamond ingot or a block having a {100} plane as a main surface is two-dimensionally scanned with laser light, a modified layer develops on a {111} plane, which is a cleavage plane, and cleavage easily occurs not on a {100} plane but on a {111} plane. Therefore, it is not easy to create a desired diamond substrate having a {100} plane as a main surface.

It is an object of the present invention to provide a method of manufacturing a single crystal diamond substrate in which a diamond substrate having a {100} plane as a main surface is manufactured from a single crystal diamond having a {100} plane as a main surface.

SOLUTION TO PROBLEM

To solve the problem above, a method of manufacturing a diamond substrate according to this application includes: a step of arranging a laser condenser to condense laser light, to face a {100} plane of a single crystal diamond block, which is a main surface; a step of performing prior processing on a first starting point and a second starting point respectively set on a first crystal face and a second crystal face from among crystal faces constituting a {111} plane, by condensing the laser light using the laser condenser, the first crystal face and the second crystal face forming a wedge structure whose tip becomes thinner toward the main surface inside the single crystal diamond block; and a step of forming a scanning line unit by condensing the laser light using the laser condenser, and forming a first scanning line and a second scanning line on the first crystal face and the second crystal face, respectively, using processing marks from the first starting point and the second starting point toward the main surface, the first scanning line and the second scanning line being connected at the tip of the wedge structure.

Forming the first scanning line and the second scanning line may include forming a modified layer including processing marks obtained by pyrolyzing diamond into graphite, and a cleavage of the {111} plane around the processing marks.

The prior processing may be processing of forming processing marks on the first starting point and the second starting point. The prior processing may be processing of forming a first prior scanning line and a second prior scanning line on the first crystal face and the second crystal face, respectively, using processing marks from the first starting point and the second starting point to the tip of the wedge structure.

The first starting point and the second starting point may be formed at the same depth from the main surface. The scanning line unit may be formed by an isosceles triangle having a line segment connecting the first starting point and the second starting point as the bottom, and the first scanning line and the second scanning line as sides.

The method may further include a step of performing another prior processing, for another first crystal face and another second crystal face, on another first starting point on the other first crystal face, the other first starting point obtained by redesignating the second starting point, and another second starting point set on the other second crystal face, by condensing the laser light using the laser condenser, the other first crystal face and the other second crystal face being parallel to the first crystal face and the second crystal face, respectively, and forming another wedge structure whose tip becomes thinner toward the main surface inside the single crystal diamond block; and a step of forming another scanning line unit by condensing the laser light using the laser condenser, and forming another first scanning line and another second scanning line on the another first crystal face and the another second crystal face, respectively, using processing marks from the another first starting point and the another second starting point toward the main surface, the another first scanning line and the another second scanning line being connected at the tip of the other wedge structure.

The step of forming the other first scanning line and the other second scanning line may include a step of forming a modified layer including processing marks obtained by pyrolyzing diamond into graphite, and cleavages of {111} planes around the processing marks.

The other prior processing may be processing of forming processing marks on the other first starting point and the other second starting point. The other prior processing may be processing of forming another first prior scanning line and another second prior scanning line on the other first crystal face and the other second crystal face, respectively, using processing marks from the other first starting point and the other second starting point to the tip of the other wedge structure.

The method may further include a step of redesignating the other scanning line unit as the scanning line unit. The method may further include a step of forming a scanning line by successively adding the scanning line unit through repeating: a step of redesignating the other scanning line unit as the scanning line unit; a step of redesignating the second starting point as the other first starting point and forming the other second starting point; and a step of configuring the other scanning line unit by forming the other first scanning line and the other second scanning line from the other first starting point and the other second starting point, respectively.

The method may further include a step of forming a plurality of scanning lines in parallel to each other inside the single crystal diamond block. The first scanning line and the second scanning line, which constitute the scanning line unit of the scanning line, may be formed on a common crystal face with the first scanning line and the second scanning line, which constitute an adjacent scanning line unit.

Graphitized processing marks and the cleavage generated therearound on the {111} plane of the modified layer formed on each scanning line may develop between adjacent scanning lines, thereby forming the modified layer, which extends along the {100} plane parallel to the main surface. The method may further include a step of dividing the single crystal diamond block along the cleavage of the {111} plane developed between the processing marks in the modified layer.

ADVANTAGEOUS EFFECTS OF INVENTION

According to the present invention, a {100} substrate can be produced with a reduced processing loss from a bulk crystal of single crystal diamond having a {100} plane as a main surface, and a single crystal diamond ingot or block obtained by an HTHP method, and consequently, the yield in producing a diamond substrate can be improved.

BRIEF DESCRIPTION OF DRAWINGS

[FIG. 1] FIG. 1 is a perspective view illustrating a schematic configuration of a processing device.

[FIG. 2A] FIG. 2A is a schematic diagram illustrating a {111} plane of a single crystal diamond (100) surface.

[FIG. 2B] FIG. 2B is a schematic diagram illustrating a {111} plane of a single crystal diamond (100) surface.

[FIG. 3A] FIG. 3A is a schematic diagram illustrating crystal orientation toward a main surface along a single crystal diamond {111} plane.

[FIG. 3B] FIG. 3B is a schematic diagram illustrating crystal orientation toward a main surface along a single crystal diamond {111} plane.

[FIG. 4] FIG. 4 is a cross-sectional view illustrating a scanning line unit.

[FIG. 5A] FIG. 5A is a cross-sectional view illustrating formation of a scanning line unit.

[FIG. 5B] FIG. 5B is a cross-sectional view illustrating formation of a scanning line unit.

[FIG. 5C] FIG. 5C is a cross-sectional view illustrating formation of a scanning line unit.

[FIG. 5D] FIG. 5D is a cross-sectional view illustrating formation of a scanning line unit.

[FIG. 6A] FIG. 6A is a cross-sectional view illustrating formation of a scanning line.

[FIG. 6B] FIG. 6B is a cross-sectional view illustrating formation of a scanning line.

[FIG. 6C] FIG. 6C is a cross-sectional view illustrating formation of a scanning line.

[FIG. 6D] FIG. 6D is a cross-sectional view illustrating formation of a scanning line.

[FIG. 7] FIG. 7 is a perspective view illustrating formation of a modified layer.

[FIG. 8] FIG. 8 is a cross-sectional view illustrating a modified layer.

[FIG. 9A] FIG. 9A illustrates a scanning line formed in a scanning method of laser light according to an embodiment.

[FIG. 9B] FIG. 9B illustrates a scanning line formed in a scanning method of laser light according to an embodiment.

[FIG. 9C] FIG. 9C illustrates a scanning line formed in a scanning method of laser light according to an embodiment.

[FIG. 10A] FIG. 10A is a perspective view illustrating a scanning method of laser light according to a variant.

[FIG. 10B] FIG. 10B is a perspective view illustrating a scanning method of laser light according to a variant.

[FIG. 11] FIG. 11 is a photograph showing a scanning line formed in a scanning method of laser light according to a variant.

[FIG. 12A] FIG. 12A is a photograph showing a block processed in a scanning method of laser light according to a variant.

[FIG. 12B] FIG. 12B is a photograph showing a block processed in a scanning method of laser light according to a variant.

[FIG. 13A] FIG. 13A is a photograph showing a surface stripped off from a block processed in a scanning method of laser light according to a variant.

[FIG. 13B] FIG. 13B is a photograph showing a surface stripped off from a block processed in a scanning method of laser light according to a variant.

[FIG. 14A] FIG. 14A is a schematic diagram illustrating a scanning method of laser light according to an Experimental Example.

[FIG. 14B] FIG. 14B is a schematic diagram illustrating a scanning method of laser light according to an Experimental Example.

[FIG. 14C] FIG. 14C is a schematic diagram illustrating a scanning method of laser light according to an Experimental Example.

[FIG. 14D] FIG. 14D is a schematic diagram illustrating a scanning method of laser light according to an Experimental Example.

[FIG. 15] FIG. 15 is a photograph showing a processing mark formed in the scanning method in FIG. 14.

[FIG. 16] FIG. 16 is a photograph showing a processing mark formed in the scanning method in FIG. 14.

[FIG. 17A] FIG. 17A is a photograph showing a processing mark formed in the scanning method in FIG. 14.

[FIG. 17B] FIG. 17B is a photograph showing a processing mark formed in the scanning method in FIG. 14.

[FIG. 17C] FIG. 17C is a photograph showing a processing mark formed in the scanning method in FIG. 14.

[FIG. 18] FIG. 18 is a schematic diagram illustrating a scanning method using laser light according to a Comparative Example.

[FIG. 19A] FIG. 19A is a diagram illustrating a scanning line formed in a scanning method of laser light according to a Comparative Example.

[FIG. 19B] FIG. 19B is a diagram showing a scanning line formed in a scanning method of laser light according to a Comparative Example.

## DESCRIPTION OF EMBODIMENTS

Next, embodiments of the present invention will be described with reference to the drawings. In the following description of the drawings, identical or similar parts are denoted by identical or similar reference numerals. However, it should be noted that the drawings are schematic, and the relationship between the thickness and the plane dimension, the ratios of the thickness of layers, or the like, are different from the actual ratios. Therefore, specific thicknesses and dimensions should be determined with reference to the following description. Needless to say, there are sections where dimensional relationships or ratios differ between the drawings.

Further, the following embodiments illustrate a device and a method for embodying the technical concept of the present invention, and the embodiments of the present invention do not specify the following materials, shapes, structures, arrangements, or the like, of components. The embodiments of the present invention may be modified within the scope of the claims.

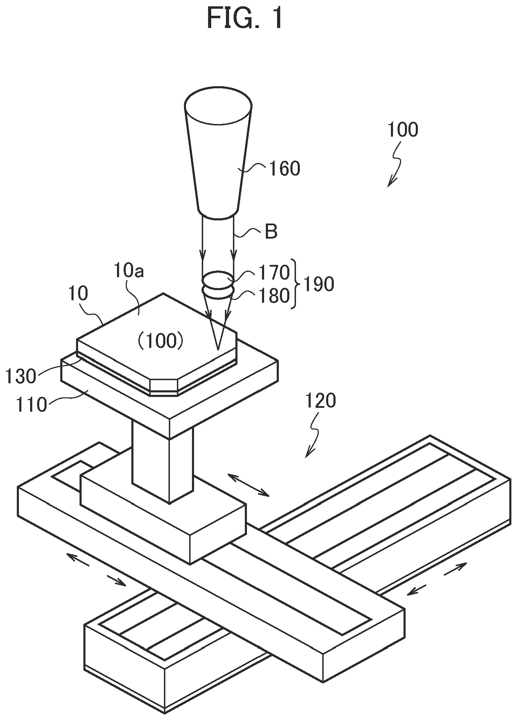

FIG. 1 is a perspective view illustrating a schematic configuration of a processing device 100. The processing device 100 includes a stage 110 on which a single crystal diamond block 10 is placed, a stage support 120 for supporting the stage 110 to be movable in an XY direction in a horizontal plane, and a fixture 130 for fixing the single crystal diamond block 10. An adhesive layer, a mechanical chuck, an electrostatic chuck, a vacuum chuck, or the like can be applied to the fixture 130.

A single crystal diamond ingot, which is an object to be processed, is cut to a predetermined length to obtain the single crystal diamond block 10, which is plate-like, having a rectangular outer periphery. The single crystal diamond block 10 is fixed on the stage 110. An upper surface of the single crystal diamond block 10 is configured to be a (100) surface having an off-angle of 0°, forming a main surface 10a. In this embodiment, the (100) surface will be described as an example of the {100} plane, but the same can be applied to other planes included in the {100} plane. The shape of the object to be processed is not limited to the description above, and may be, for example, an ingot of single crystal diamond, a wafer in a disc shape, or a bulk crystal of single crystal diamond, as long as the main surface 10a is the (100) surface.

The processing device 100 includes a laser light source 160 for generating pulsed laser light, and a laser condenser 190 including an objective lens 170 and an aberration adjusting section 180. Laser light B is emitted from the laser light source 160, and irradiated toward the (100) surface of the main surface 10a of the single crystal diamond block 10 via the laser condenser 190.

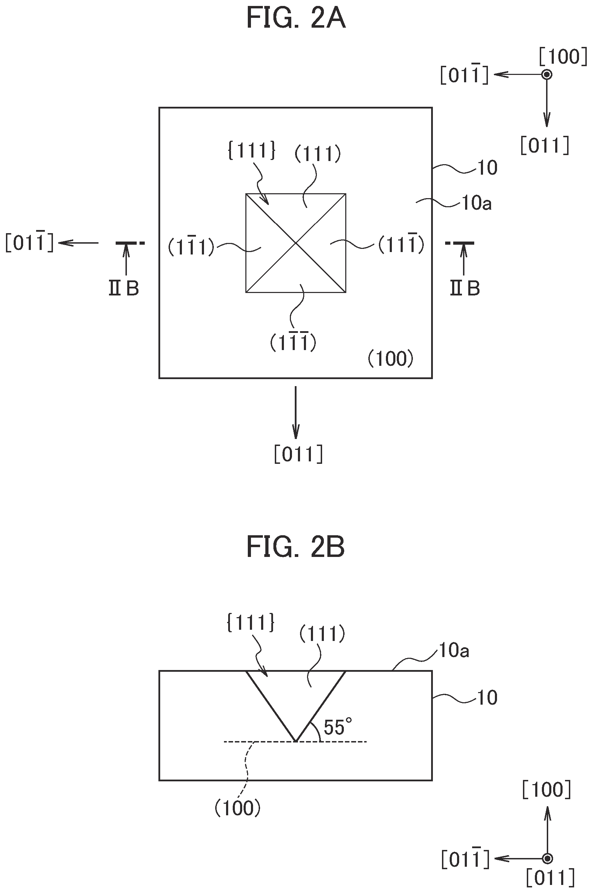

FIG. 2 is a schematic diagram illustrating arrangement of {111} planes in a crystal structure of the single crystal diamond block 10 having the (100) surface as the main surface when viewed from the main surface 10a formed by an upper surface of the single crystal diamond block 10. FIG. 2A is a top view of the single crystal diamond block 10, and FIG. 2B is a cross-sectional view of the single crystal diamond block 10 in FIG. 2A taken along a cutting line IIB-IIB. In the drawings, the orientations [110] and [01-1] are also indicated, respectively. As illustrated in FIG. 2A, there are four {111} planes of (111), (1-11), (1-1-1), and (11-1) in a quadrangular pyramid having a (100) surface as its bottom surface. Further, as illustrated in FIG. 2B, the {111} plane has an angle of 55° with respect to the (100) surface. Due to limitation on signs that can be used in this specification, an upper line attached to a number for displaying the Miller index will be replaced by a minus sign "-" before the number, for the sake of convenience. The same applies hereinafter.

Here, a carbon atom in a diamond crystal is covalently bonded to adjacent carbon elements by arms of sp3 hybrid orbitals extending in the direction of the four vertexes of a regular tetrahedron centered on the carbon atoms. The carbon atoms covalently bonded to the adjacent four carbon atoms form a body-centered cubic lattice called a diamond structure. It is known that single crystal diamond is very hard because carbon atoms form covalent bonds with four neighboring carbon atoms in the diamond structure. However, a carbon atom is covalently bonded to one neighboring carbon atom in the <111> direction by a single arm of sp3 hybridization orbital. Therefore, carbon atoms can be separated relatively easily by breaking only this single arm covalent bond in the {111} plane direction orthogonal to the <111> direction, and this {111} plane becomes a cleavage plane.

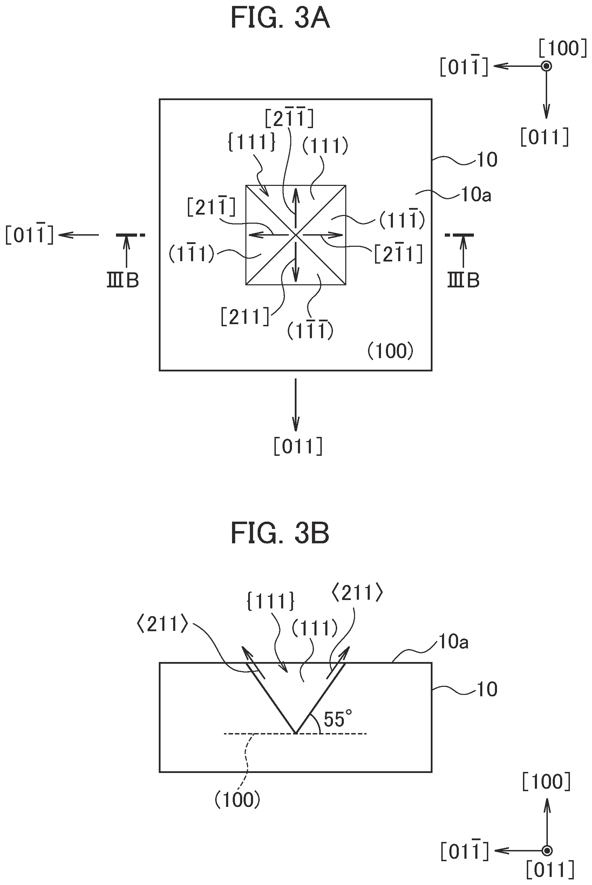

FIG. 3 is a schematic diagram for explaining the crystal orientation toward the main surface along the {111} plane of single crystal diamond with the (100) surface as the main surface. FIG. 3A is a top view of the single crystal diamond block 10, and FIG. 3B is a cross-sectional view obtained by cutting the single crystal diamond block 10 illustrated in FIG. 3A along the cutting line IIIB-IIIB. FIG. 3A illustrates orientations of a crystal along four planes (111), (1-11), (1-1-1), and (11-1) toward the base of the pyramid, that is, toward the main surface 10a of the single crystal diamond block 10 with an off-angle of 0°, in a [2-1-1] direction along a (111) surface, a [21-1] direction along a (1-11) surface, a [211] direction along a (1-1-1) surface, and a [2-11] direction along a (11-1) surface. That is, as illustrated in FIG. 3B, the crystal orientation toward the surface of the single crystal diamond block 10 along the {111} plane is <211>. This arrangement is shown in Table 1.

[Table 1]

| Crystal Plane | Crystal Orientation along Crystal Plane |
|---|---|
| (111) | [2-1-1] |
| (1-11) | [21-1] |
| (1-1-1) | [211] |

6

(continued)

| Crystal Plane | Crystal Orientation along Crystal Plane |
|---|---|
| (11-1) | [2-11] |

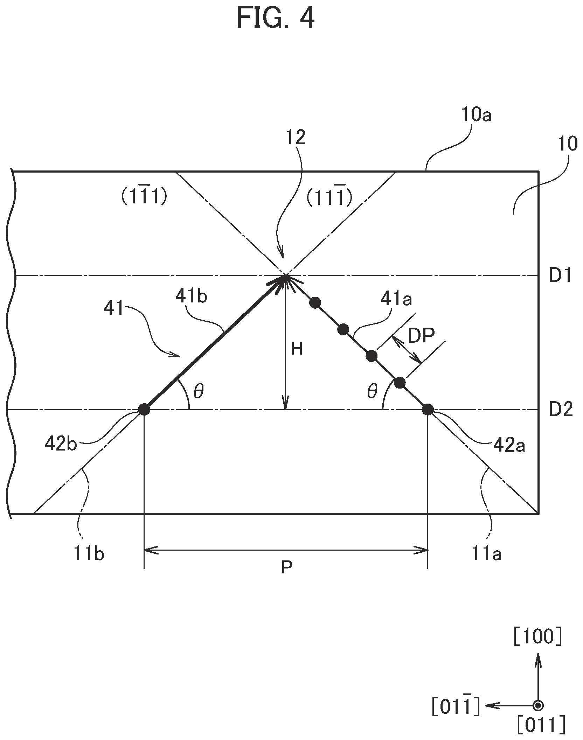

FIG. 4 is a cross-sectional view illustrating a scanning line unit. In a scanning method of the laser light B in the present embodiment, a scanning line formed by the laser light B emitted from the laser condenser 190 to the single crystal diamond block 10 is configured by a scanning line unit 41. With respect to the (1-11) surface of a first crystal face 11a and the (11-1) surface of a second crystal face 11b forming a wedge structure 12, a tip thereof becoming thinner toward the (100) surface of the main surface 10a at a first depth D1 from the main surface 10a and extending in a [011] direction, from among crystal faces constituting the {111} surfaces in the single crystal diamond block 10, the scanning line unit 41 includes a first scanning line 41a formed in the [21-1] direction toward the main surface 10a from a first starting point 42a formed using processing marks at a second depth D2 from the main surface 10a on the first crystal face 11a, and a second scanning line 41b formed in the [2-11] direction toward the main surface 10a from a second starting point 42b formed using processing marks at a second depth D2 from the main surface 10a on the second crystal face 11b; and the first scanning line 41a and the second scanning line 41b are connected at the tip of the wedge structure 12.

The first starting point 42a and the second starting point 42b are formed prior to the formation of the first scanning line 41a and the second scanning line 41b, respectively. The first scanning line 41a and the second scanning line 41b are formed by scanning the laser light B using a dot pitch DP while focusing the laser light B to the first starting point 42a and the second starting point 42b, formed in advance. The first starting point 42a and the second starting point 42b are processing marks formed at the focus points by focusing the laser light B. The processing marks need not be graphitized, but are preferably graphitized to enhance the focusing effect even when output of the laser light B in the scanning line formation process is lowered. In this embodiment, crystal phase transitions occur at the starting points described as the first starting point 42a and the second starting point 42b, and graphite processing marks are easily formed by focusing the laser light B to the starting points during formation process of the scanning lines described as the first scanning line 41a and the second scanning line 41b.

The first scanning line 41a and the second scanning line 41b form a modified layer including graphitized processing marks formed at intervals of the dot pitch DP and cleavage along the {111} plane, which is a cleavage plane generated around the processing marks along with a volume change caused by graphite. It should be noted that the processing marks at the first starting point 42a and the second starting point 42b, which are formed prior to the first scanning line 41a and the second scanning line 41b, may be referred to as processing marks formed by prior processing. The prior processing is a processing performed to cause a phase transition of the crystal in the condenser. A volume change is caused by the phase transition, and the purpose of the prior processing is to induce a local phase transition by controlling energy applied to the crystal so that the cleavage along an unexpected crystal orientation is not spread due to the volume change.

In the scanning line unit 41, the first scanning line 41a is formed to extend in the [21-1] direction, the second scanning line 41b is formed to extend in the [2-11] direction. The first scanning line 41a and the second scanning line 41b connected at the tip of the wedge structure 12 are located in the same plane and constitute sides of an isosceles triangle. The isosceles triangle satisfies the following relational expression (1), where a starting point pitch P, which is the interval between the first starting point 42a and the second starting point 42b, is the length of the base, the height H is from the second depth D2 to the first depth D1, and the base angle is $\theta$. As described above, the base angle $\theta$ is 55°.
[Mathematical Formula 1]

$$H = \frac{P}{2}\tan\theta \quad (1)$$

According to the relational expression (1), the starting point pitch P is given by the relational expression (1) based on the height H from the second depth D2 to the first depth D1, and the base angle $\theta$. In other words, the second starting point 42b should be formed at a location away by the starting point pitch P given by the height H and the base angle $\theta$ in the [01-1] direction of the bottom with the first starting point 42a as a reference. Further, the distance between the depths D1 and D2, that is, the processing area is reduced when the height H in the relational expression (1) is decreased, thereby reducing processing loss.

In general, with respect to the first crystal face 11a and the second crystal face 11b forming a wedge structure 12, a tip thereof becoming thinner toward the {100} surface of the main surface 10a at the first depth D1 from the main surface 10a, in the single crystal diamond block 10 having a {100} face as the main surface 10a, the scanning line unit 41 includes the first scanning line 41a formed toward the main surface 10a on the first crystal face 11a, and the second scanning line 41b formed toward the main surface 10a from the second starting point 42b on the second crystal face 11b; and the first scanning line 41a and the second scanning line 41b are connected at the tip of the wedge structure 12. The first scanning line 41a and the second scanning line 41b connected at the tip of the wedge structure 12 are located in the same plane in this case as well, and constitute sides of an isosceles triangle. The isosceles triangle satisfies the following relational expression (1), where the starting point pitch P, which is the interval between the first starting point 42a and the second starting point 42b, is the length of the base, the height H is from the second depth D2 to the first depth D1, and the base angle is $\theta$.

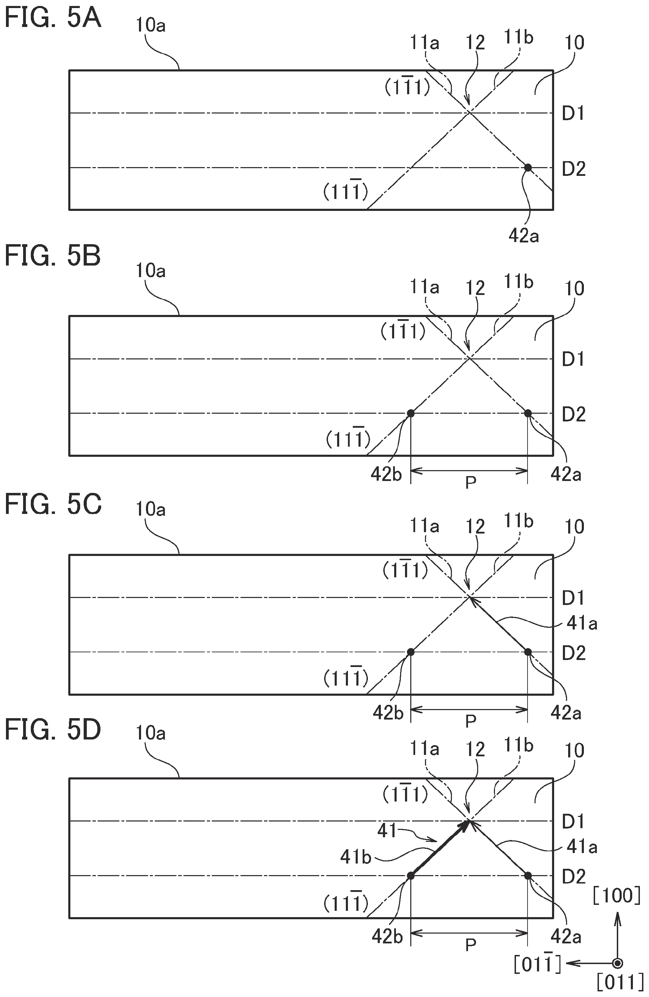

FIG. 5 is a cross-sectional view illustrating formation of the scanning line unit 41. As illustrated in FIG. 5A, in the interior of the single crystal diamond block 10, the (1-11) surface of the first crystal face 11a and the (11-1) surface of the second crystal face 11b form the wedge structure 12, a tip thereof becoming thinner toward the (100) surface of the main surface 10a and extending in the [011] direction. At the first crystal face 11a, the laser light B is condensed by the laser condenser 190 to form the first starting point 42a using processing marks at the second depth D2 from the main surface 10a.

As illustrated in FIG. 5B, after formation of the first starting point 42a, the laser light B is condensed by the laser condenser 190 and the second starting point 42b is formed using processing marks on the second crystal face 11b at the second depth D2 from the main surface 10a. As described above, the first starting point 42a and the second starting point 42b correspond to apexes of the bottom of the isosceles triangle having the first scanning line 41a and the second scanning line 41b as sides. Therefore, the second starting point 42b is located at a location away by the starting point pitch P in the [01-1] direction orthogonal to the direction, in which the tip of the wedge structure 12 extends, with respect to the first starting point 42a. The starting point pitch P is given by the relational expression (1), where the height H is from the second depth D2 to the first depth D1 and the base angle of the isosceles triangle is $\theta$.

As illustrated in FIG. 5C, after formation of the second starting point 42b, the (1-11) surface of the first crystal face 11a is irradiated with the laser light B from the laser condenser 190 to form the first scanning line 41a from the first starting point 42a to the tip of the wedge structure 12. By condensing and irradiating the laser light B at the first starting point 42a, a modified layer including a graphitized processing mark in the scanning direction of the first scanning line 41a and a cleavage along the (1-11) surface around the processing mark is formed.

Further, as illustrated in FIG. 5D, the (11-1) surface of the second crystal face 11b is irradiated with the laser light B from the laser condenser 190 to form the second scanning line 41b from the second starting point 42b to the tip of the wedge structure 12. Similarly to the description above, a graphitized region and a peripheral cleavage are also formed on the second scanning line 41b. The first scanning line 41a and the second scanning line 41b are connected at the tip of the wedge structure 12. Thus, the scanning line unit 41 is formed by the first scanning line 41a and the second scanning line 41b being connected.

Here, a connected state means a state in which modified layers constituting the first scanning line 41a and the second scanning line 41b are connected at the first depth D1. More specifically, the modified layers of the first scanning line 41a and the second scanning line 41b are in any of the following states: focus points of the laser light B overlap; the focus points do not overlap and graphite regions are connected, or neither the focus points nor the graphite regions are connected and the peripheral cleavages are connected. In any of the states above, it is necessary that the first scanning line 41a and the second scanning line 41b do not extend from the tip of the wedge structure 12 in the direction of the main surface. This is realized by optimization of laser processing conditions and high-precision processing position control.

In general, when the main surface 10a of the single crystal diamond block 10 is a {100} plane, the laser light B is condensed by the laser condenser 190, and the first starting points 42a and the second starting points 42b are formed using processing marks on the first crystal face 11a and the second crystal face 11b, respectively, from among the crystal faces constituting the {111} plane, the first crystal face 11a and the second crystal face 11b forming the wedge structure 12, a tip thereof becoming thinner toward the main surface 10a in the single crystal diamond block 10. The laser light B is condensed by the laser condenser 190, and the first scanning line 41a and the second scanning line 41b are formed using processing marks from the first starting point 42a and the second starting point 42b toward the main surface 10a on the first crystal face 11a and the second crystal face 11b, respectively. The first scanning line 41a and the second scanning line 41b are connected at the tip of the wedge structure 12 to form the scanning line unit 41.

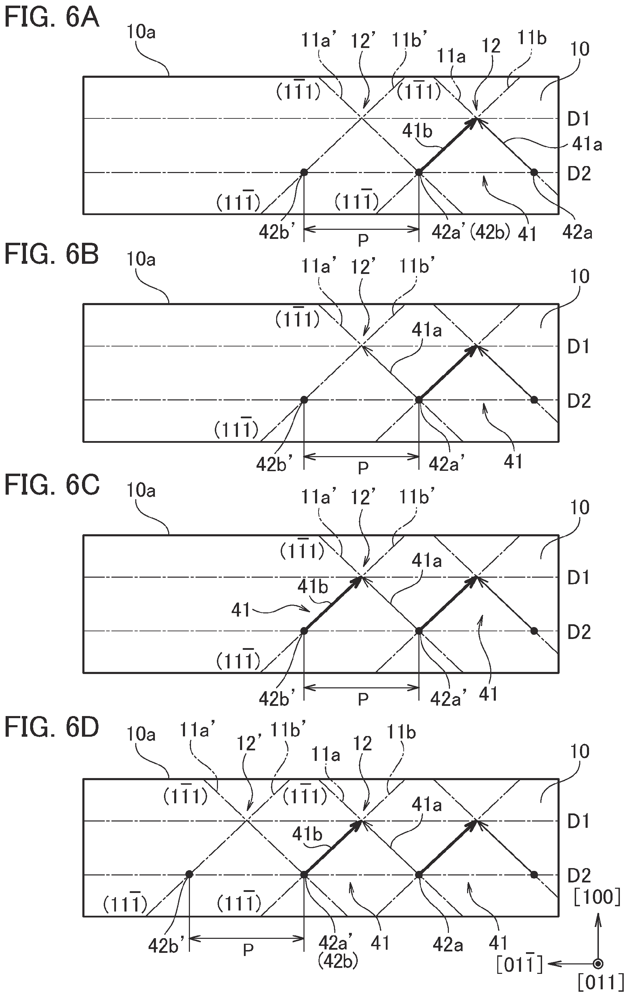

FIG. 6 is a cross-sectional view illustrating formation of a scanning line. In FIG. 6, another scanning line unit 41' is added to the scanning line unit 41 formed in the single crystal diamond block 10 as illustrated in FIG. 5D to form a scanning line.

As illustrated in FIG. 6A, the (1-11) surface of another first crystal face 11a' and the (11-1) surface of another second crystal face 11b' are parallel to the (1-11) surface of the first crystal face 11a and the (11-1) surface of the second crystal face 11b, respectively, inside the single crystal diamond block 10, and form another wedge structure 12', a tip thereof becoming thinner toward the (100) surface of the main surface 10a and extending in the [011] direction. The second starting point 42b is redesignated as another first starting point 42a'. The other first crystal face 11a' is selected to pass through the other first starting point 42a'.

As illustrated in FIG. 6B, after redesignation of the other first starting point 42a', the laser light B is condensed by the laser condenser 190 onto the other second crystal face 11b' to form another second starting point 42b' at the second depth d2 from the main surface 10a. The other first starting point 42a' and the other second starting point 42b' correspond to the apexes of the bottom of an isosceles triangle where sides thereof are another first scanning line 41a' and another second scanning line 41b', which will be described below. Therefore, the other second starting point 42b' is located away by the starting point pitch P in the [01-1] direction orthogonal to the direction, in which the tip of the other wedge structure 12' extends, with respect to the other first starting point 42a'. As described above, the starting point pitch P is given by the relational expression (1), where the height H is from the second depth D2 to the first depth D1 and the base angle of the isosceles triangle is 0.

As illustrated in FIG. 6C, after formation of the other second starting point 42b', the (1-11) surface of the other first crystal face 11a' is irradiated with the laser light B from the laser condenser 190 to form the other first scanning line 41a' from the other first starting point 42a' to the tip of the other wedge structure 12'. Further, the (11-1) surface of the other second crystal face 11b' is irradiated with the laser light B from the laser condenser 190 to form the other second scanning line 41b' from the other second starting point 42b' to the tip of the other wedge structure 12'. The other first scanning line 41a' and the other second scanning line 41b' are connected at the tip of the other wedge structure 12', and another scanning line unit 41' is formed by connecting the other first scanning line 41a' and the other second scanning line 41b'.

As illustrated in FIG. 6D, the other scanning line unit 41' is redesignated as the scanning line unit 41. The other first starting point 42a', the other second starting point 42b', the other first scanning line 41a', and the other second scanning line 41b' constituting the other scanning line unit 41' are also redesignated as the first starting point 42a, the second starting point 42b, the first scanning line 41a, and the other second scanning line 41b, respectively. Similarly, the other first crystal face 11a', the other second crystal face 11b', and the other wedge structure 12' are redesignated as the first crystal face 11a, the second crystal face 11b, and the wedge structure 12, respectively.

Similarly to the process illustrated in FIG. 6A, in FIG. 6D, the (1-11) surface of the other first crystal face 11a' and the (11-1) surface of the other second crystal face 11b' are parallel to the (1-11) surface of the first crystal face 11a and the (11-1) surface of the other second crystal face 11b, respectively, inside the single crystal diamond block 10, and form the other wedge structure 12' a tip thereof thinned toward the (100) surface of the main surface 10a and extending in the [011] direction. In the other first crystal face 11a', the second starting point 42b is redesignated as the other first starting point 42a'. The other first crystal face 11a' is selected to pass through the other first starting point 42a'. The laser light B is condensed by the laser condenser 190 onto the other second crystal face 11b', to form the second starting point 42b' at the second depth d2 from the main surface 10a. The other second starting point 42b' is located away by the starting point pitch P in the [01-1] direction orthogonal to the other wedge structure 12' with respect to the other first starting point 42a'. The operation described above is then repeated to form the scanning line unit 41'. Thus, a scanning line is formed by adding the other scanning line unit 41' to the scanning line unit 41.

In general, when the main surface 10a of the single crystal diamond block 10 is a {100} plane, the second starting point 42b is redesignated as the other first starting point 42a' on the other first crystal face 11a', with respect to the other first crystal face 11a' and the other second crystal face 11b' which are parallel to the first crystal face 11a and the second crystal face 11b, respectively, and which form the wedge structure 12', a tip thereof becoming thinner toward the main surface 10a. The other first crystal face 11a' is selected to pass through the other first starting point 42a'. The laser light B is condensed by the laser condenser 190 to form the other second starting point 42b' on the other second crystal face 11b' using a processing mark. The laser light B is condensed by the laser condenser 190 to form the other first scanning line 41a' and the other second scanning line 41b' using processing marks toward the main surface 10a from the other first starting point 42a' and the other second starting point 42b' on the other first crystal face 11a' and the other second crystal face 11b', respectively. The other first scanning line 41a' and the other second scanning line 41b' are connected at the other edge 12' to constitute the other scanning line unit 41'. The other scanning line unit 41' thus formed is redesignated as the scanning line unit 41, and the other scanning line unit 41' is added to the scanning line unit 41 to form a scanning line.

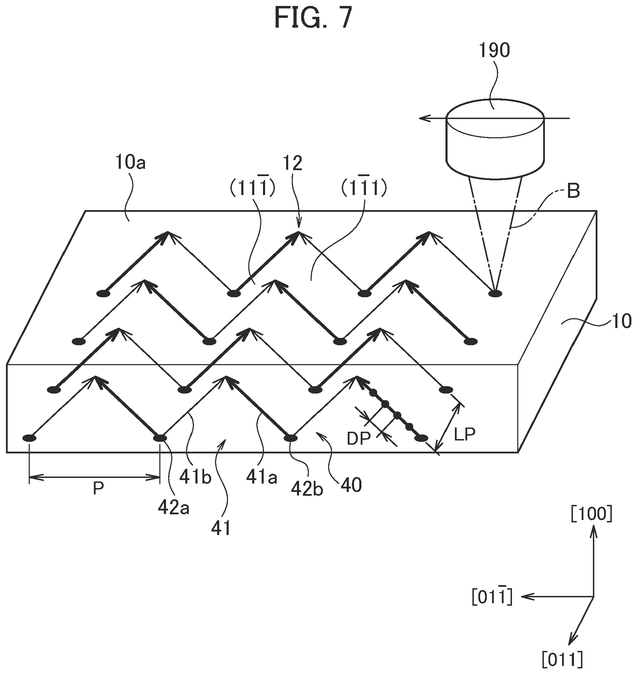

FIG. 7 is a perspective view illustrating formation of a modified layer on the single crystal diamond block 10. Modified layers constituting the scanning line 40 are formed in parallel, so that the modified layers covering an entire main surface 10a of the single crystal diamond block 10 are formed. As illustrated in FIG. 7, the scanning line unit 41 is added from one end to the other end of the single crystal diamond block 10 to form the scanning line 40. When the scanning line 40 reaches the other end of the single crystal diamond block 10, the position at which the laser light B is irradiated is moved from the scanning line 40 in the [011] direction in which the tip of the wedge structure 12 extends, for example, at an interval of a line pitch LP, and the scanning line unit 41 is added from the other end to one end of the single crystal diamond block 10 to form the scanning line 40. By repeating this type of operation, the scanning line 40 is formed over the entire main surface 10a at a predetermined depth from the main surface 10a of the single crystal diamond block 10.

Here, the first scanning lines 41a and the second scanning lines 41b in the opposing scanning line units 41 of the adjacent scanning lines 40 may be formed on a common crystal face. For example, the first crystal face 11a and the second crystal face 11b, on which the first scanning line 41a and the second scanning line 41b of the scanning line unit 41 constituting a certain scanning line 40 are formed, may be common to the other second crystal face 11b' and the other first crystal face 11a', on which the second scanning line 41b' and the first scanning line 41a' of the opposing scanning line unit 41' are formed in the other adjacent scanning line 40'. Here, it is considered that the advancing direction in which the scanning line units 41 are formed is opposite in the pair of adjacent scanning lines 40. When the crystal faces of the adjacent and opposing scanning line units 41 are common, cleavages are formed between the modified layers constituting the adjacent scanning lines 40 to extend over the scanning lines 40 along the common crystal face. As the cleavages develop between the modified layers constituting the adjacent scanning lines 40, a modified layer including cleavages over the entire main surface 10a of the block is formed.

In general, even when the main surface 10a of the single crystal diamond block 10 is a {100} plane, the scanning line units 41 are added from one end toward the other end of the single crystal diamond block 10 to form the scanning line 40. When the scanning line 40 reaches the other end of the single crystal diamond block 10, a position for irradiating the laser light B is moved with an interval of the line pitch LP from the scanning line 40 in a predetermined direction in which the tip of the wedge structure 12 extends. The scanning line units 41 are then added from the other end toward one end of the single crystal diamond block 10 to form a scanning line 40. The operation is repeated, so that the scanning line 40 is formed over the entire surface of the main surface 10a at a predetermined depth from the main surface 10a of the single crystal diamond block 10. Cleavage between the modified layers constituting the scanning lines 40 develops to form a modified layer over an entire main surface.

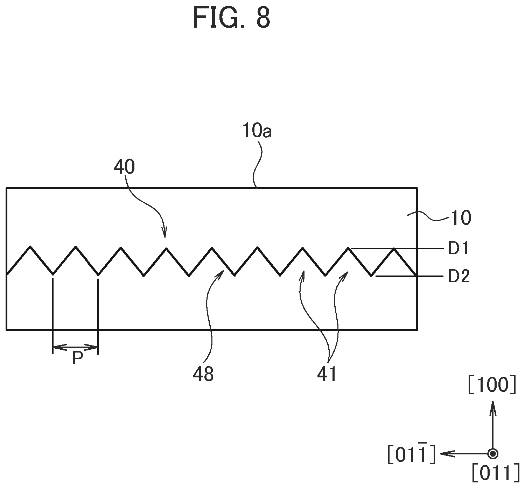

FIG. 8 is a cross-sectional view illustrating a modified layer formed on the single crystal diamond block 10. In the single crystal diamond block 10, the modified layer including a processing mark and cleavage of the {111} plane around the processing mark constitutes the scanning line 40, and cleavage also develops between the modified layers constituting the adjacent scanning lines 40 to connect a modified layer 48. The modified layer 48 extends in parallel with the (100) surface of the main surface 10a, so that a substrate thinned to a thickness from the main surface 10a to the modified layer 48 can be produced by stripping off the single crystal diamond block 10 at the modified layer 48.

In general, when the main surface 10a of the single crystal diamond block 10 is the {100} plane, the modified layer 48 is formed in parallel with the {100} plane of the main surface 10a. Therefore, a substrate thinned to a thickness from the {100} plane of the main surface 10a to the modified layer 48 can be produced by stripping off the block single crystal diamond 10 to be separated at the modified layer 48.

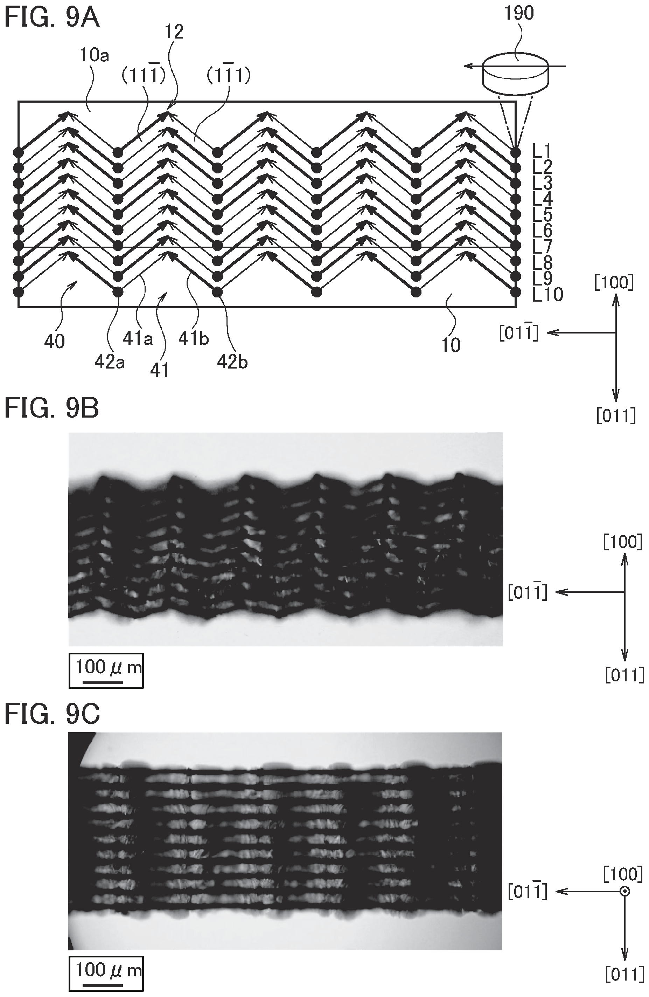

FIG. 9 is a diagram illustrating the scanning line 40 formed in the single crystal diamond block 10 in a scanning method of the laser light B according to an embodiment. FIG. 9A is a schematic view of the scanning line 40 formed in the single crystal diamond block 10, and FIG. 9B is a photograph of the scanning line 40 formed in the single crystal diamond block 10 as illustrated in FIG. 9A.

Processing conditions are shown in Table 2. The first starting point 42a and the second starting point 42b are arranged at the second depth D2 (not illustrated) at the starting point pitch P and the line pitch LP by prior processing. Next, the laser light B is scanned at the dot pitch DP from the first starting point 42a and the second starting point 42b to the first depth D1 (not illustrated) along the (11-1) surface and the (1-11) surface, and the first scanning line 41a and the second scanning line 41b are formed at the line pitch LP. The scanning line unit is formed at the starting point pitch P = 140 $\mu$m, and the height H = 100 $\mu$m. In the photograph in FIG. 9B, it is observed that the scanning line unit 41 constituting the scanning line 40 forms a modified layer including a processing mark made of graphite and a cleavage around the processing mark having a substantially uniform thickness along the scanning line 40 regardless of the first scanning line 41a and the second scanning line 41b, and that the cleavage extends between the adjacent scanning lines 40, and the modified layer is connected between the scanning lines 40.

[Table 2]

| Machining Conditions | | Origin | Scan Line |
|---|---|---|---|
| Wavelength | nm | 1030 | |
| Pulse Width | ps | 10 | |
| Transmission Frequency | kHz | 1 | |
| Pulse Energy | $\mu$J | 2 | |
| Dot Pitch (DP) | $\mu$m | - | 2 |
| Line Pitch (LP) | $\mu$m | 30 | 30 |
| Height (H) | $\mu$m | - | 100 |
| Number of Lines | Line | 10 | 10 |

(Variations)

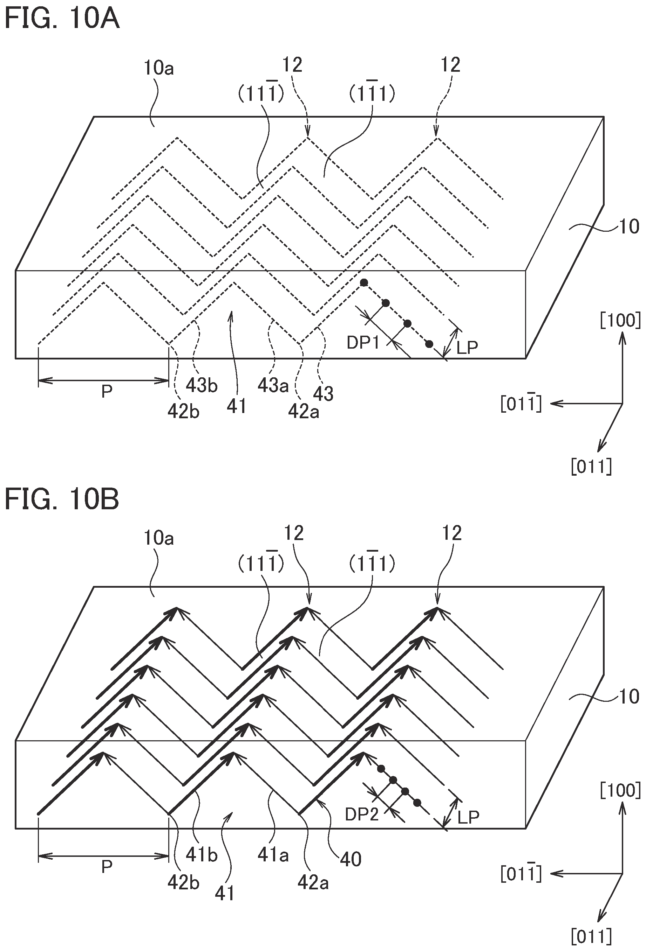

Next, a scanning method of the laser light B according to a variant will be described. FIG. 10 is a perspective view illustrating a scanning method of the laser light B according to a variant. In the scanning method according to the variant, a first prior scanning line 43a and a second prior scanning line 43b are formed from the first scanning line 42a and the second scanning line 42b to the tip of the wedge structure 12, respectively, as a prior processing of the first scanning line 42a and the second scanning line 42b, instead of forming a processing mark as illustrated in FIG. 4. The first prior scanning line 43a and the second prior scanning line 43b are connected at the edge 12 as described above. In the variant, the first scanning line 42a and the second scanning line 42b become merely starting points of the first prior scanning line 43a and the second prior scanning line 43b.

Subsequently, the first scanning line 41a and the second scanning line 41b are formed to the tip of the wedge structure 12, superimposed on the first prior scanning line 43a and the second prior scanning line 43b, and connected at the tip of the wedge structure 12 to form the scanning line unit 41. Here, it is preferable that a dot pitch DP1 of the processing marks forming the first prior scanning line 43a and the second prior scanning line 43b is larger than the second dot pitch DP2 forming the first scanning line 41a and the second scanning line 41b so that graphitization due to presence of the starting point is facilitated.

FIG. 10A is a perspective view illustrating the first prior scanning line 43a and the second prior scanning line 43b formed over the entire surface of the single crystal diamond block 10. FIG. 10B is a perspective view illustrating the first scanning line 41a and the second scanning line 41b formed over the entire surface of the single crystal diamond block 10. As described above, the first scanning line 41a and the second scanning line 41b are formed on the first prior scanning line 43a and the second prior scanning line 43b in a superimposed manner, and are connected at the tip of the wedge structure 12 to form the scanning line unit 41. As illustrated in FIG. 10A, the first prior scanning line 43a and the second prior scanning line 43b may be formed in advance over the entire surface of the main surface 10a of the single crystal diamond block 10, or as described in the steps in FIGS. 5 and 6, may be formed for each scanning line unit 41, and the scanning line 40 may be formed by adding the scanning line units 41. Further, for example, the first starting point 42a of the scanning line unit to be formed may be formed in succession to have a W-shaped cross-sectional shape at the dot pitch DP1. Thus, the first prior scanning line 43a and the second prior scanning line 43b are formed. The formation of the modified layer 48 according to the variation is the same as that of the embodiment described above.

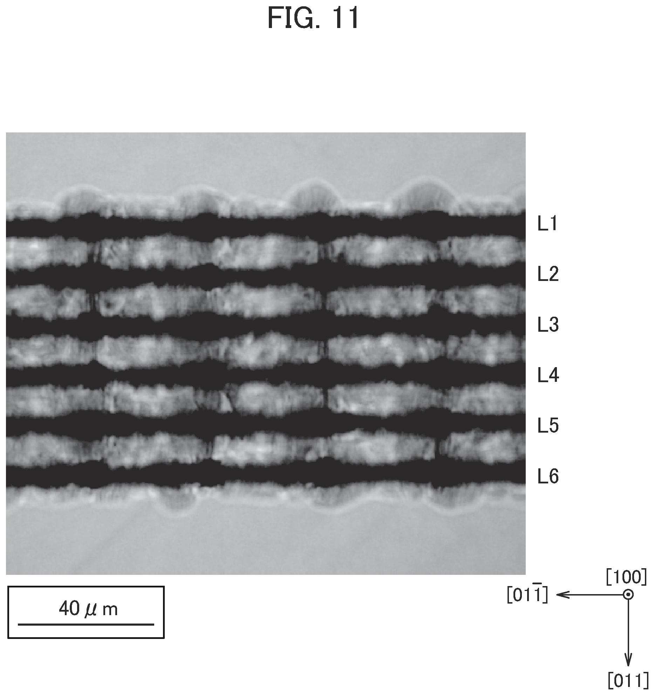

FIG. 11 is a photograph of the scanning line 40 formed in the single crystal diamond block 10 in the scanning method of the laser light B according to the variation. In FIG. 11, the line pitch LP of the scanning line 40 is 15 $\mu$m, and processing conditions are as shown in Table 3. In FIG. 11, it is observed that graphite is formed with a substantially uniform thickness along the scanning line 40 regardless of the first scanning line 41a and the second scanning line 41b of the scanning line unit 41 constituting the scanning line 40. It is also observed that cleavages extend between the modified layers constituting the adjacent scanning lines 40, and that the modified layers are connected.

[Table 3]

| Machining Conditions | | Origin | Scanning Line |
|---|---|---|---|
| Wavelength | nm | 1030 | |
| Pulse Width | ps | 10 | |
| Transmission Frequency | kHz | 0.25 | 0.1 |
| Pulse Energy | $\mu$J | 1.5 | |
| Dot Pitch (DP) | $\mu$m | 4(DP1) | 2(DP2) |
| Line Pitch (LP) | $\mu$m | 15 | 15 |
| Height (H) | $\mu$m | - | 15 |
| Number of Lines | Line | 6 | 6 |

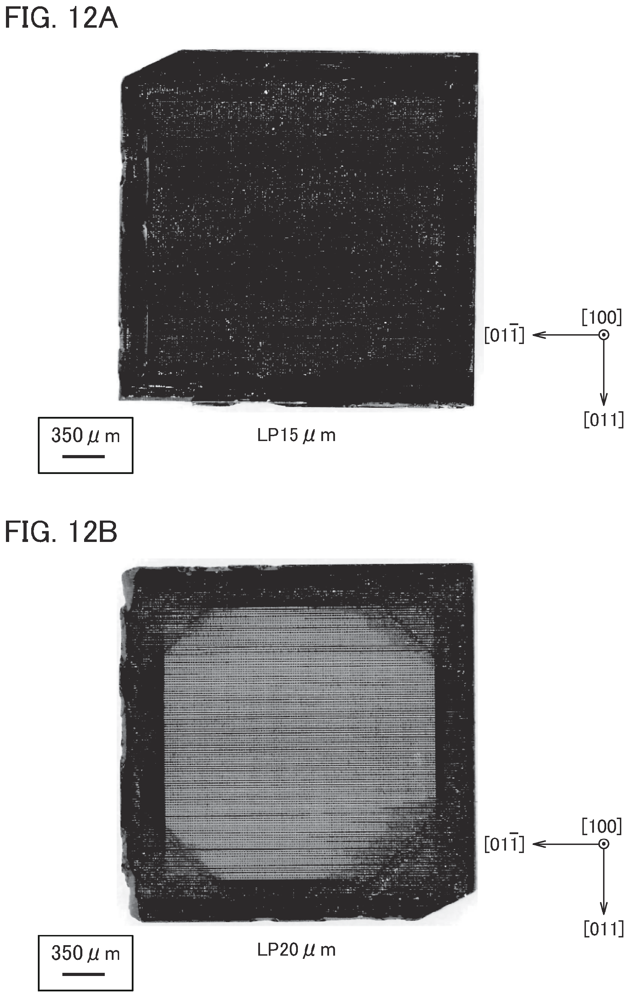

FIG. 12 is a photograph showing the single crystal diamond block 10 processed in the scanning method of the laser light B according to the variation. In FIG. 12A, the line pitch LP of the scanning line 40 shown in the processing conditions of Table 3 is 15 $\mu$m. In FIG. 12B, only the line pitch LP of the scanning line 40 is 20 $\mu$m in the processing conditions of Table 3. In FIG. 12A, where the line pitch LP is 15 $\mu$m, it is observed that the entire surface of the single crystal diamond block 10 is darkened and cleavage is developed to form a modified layer.

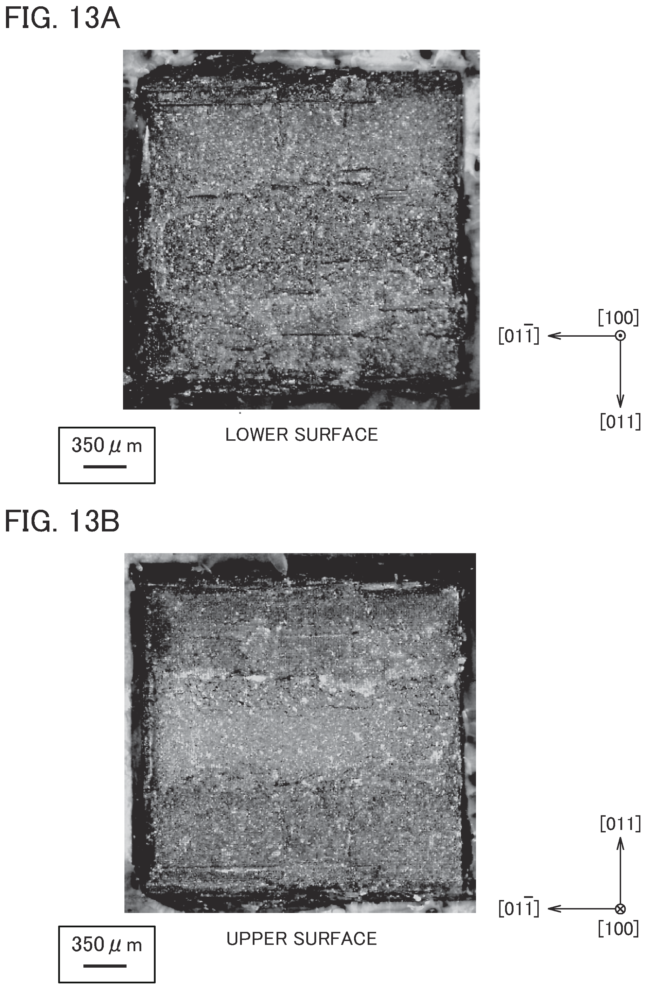

FIG. 13 is a photograph showing a surface of the single crystal diamond block 10 processed in the scanning method of the laser light B according to the variation and stripped off to be separated. FIG. 13A shows a stripped lower surface and FIG. 13B shows a stripped upper surface. In FIG. 13A showing the stripped lower surface and FIG. 13B showing the stripped upper surface, it is observed that graphite is formed along the stripped surface.

As described above, when laser light is two-dimensionally scanned on a diamond ingot or a block, a modified layer is developed on the {111} plane which is a cleavage plane around a processing mark formed of graphite, and cleavage occurs on the {111} plane to form a modified layer. It is necessary to sufficiently increase the pulse energy of the laser light to about 1 W to form a processing mark by graphitization. However, it is difficult to control spread of cleavage from the graphite region. Furthermore, if the pulse energy is insufficient, graphitization does not occur.

In the present embodiment, a modified layer is formed by cleaving the {111} plane from the graphitized processing marks with a small pulse energy of the laser light, and a previously processed starting point is used to control the spread of cleavage in the modified layer. The details will be described with reference to the following experiment. It should be noted that the processing conditions of the present embodiment are obtained by the processing device in the present embodiment. Needless to say, processing conditions are suitable set according to the specifications of the processing device. In this case, it is essential to suitably adjust the pulse energy of the laser light.

(Experiment)

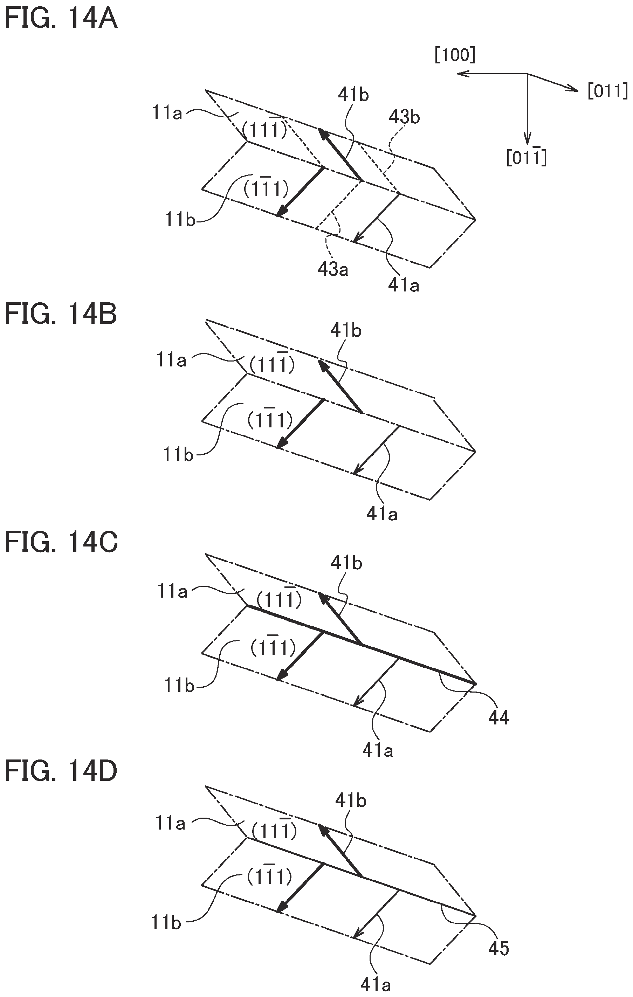

An experiment on the formation of the scanning line 40 for the scanning method of the laser light B will be described. FIG. 14 is a schematic diagram illustrating the scanning method of the laser light B according to the experiment.

In FIG. 14A, similar to the variant, in the single crystal diamond block 10, the first prior scanning line 43a was formed with a dot pitch of 4 $\mu$m in the [21-1] direction along the (1-11) surface of the first crystal face 11a, and the second prior scanning line 43b was formed with a dot pitch of 4 $\mu$m in the [2-11] direction along the (11-1) surface of the second crystal face 11b. After forming the first prior scanning line 43a and the second prior scanning line 43b, the first scanning line 41a and the second scanning line 41b were formed at a dot pitch of 2 $\mu$m to overlap a part of the first prior scanning line 43a and the second prior scanning line 43b, respectively. It should be noted that the experiment is performed regarding formation of the scanning line 40, and the state in which the first prior scanning line 43a and the second prior scanning line 43b are connected at the tip of the wedge structure 12As is not required as in the embodiment and the variation.

In FIG. 14B, for the single crystal diamond block 10, the first scanning line 41a was formed at a dot pitch of 2 $\mu$m in the [21-1] direction along the (1-11) surface of the first crystal face 11a without forming a starting point, and the second scanning line 41b was formed at a dot pitch of 4 $\mu$m in the [2-11] direction along the (11-1) surface of the second crystal face 11b.

In FIG. 14C, a reference line 44 was formed at a dot pitch of 2 $\mu$m in a valley formed by the (1-11) surface of the first crystal face 11a and the (11-1) surface of the first crystal face 11a and extending in the [0-1-1] direction by irradiation of the laser light B. On the reference line 44, the graphitized processing marks were formed in succession as starting points by prior processing. After forming the reference line 44, the first scanning line 41a was formed from the reference line 44 at a dot pitch of 4 $\mu$m in the [21-1] direction along the (1-11) surface of the first crystal face 11a, and similarly, the first scanning line 41a was formed from the reference line 44 at a dot pitch of 4 $\mu$m in the [2-11] direction along the (11-1) surface of the second crystal face 11b.

In FIG. 14D, the reference line 45 was formed at a dot pitch of 4 $\mu$m in a valley formed by the (1-11) surface of the first crystal face 11a and the (11-1) surface of the second crystal face 11a, and extending in the [0-1-1] direction by irradiation of the laser light B. Graphitized processing marks were intermittently formed on the reference line 45, as starting points by prior processing. After forming the reference line 45, the first scanning line 41a was formed along the (1-11) surface of the first crystal face 11a with a dot pitch of 4 $\mu$m in the [21-1] direction, and the first scanning line 41a was formed along the (11-1) surface of the second crystal face 11b with a dot pitch of 4 $\mu$m in the [2-11] direction.

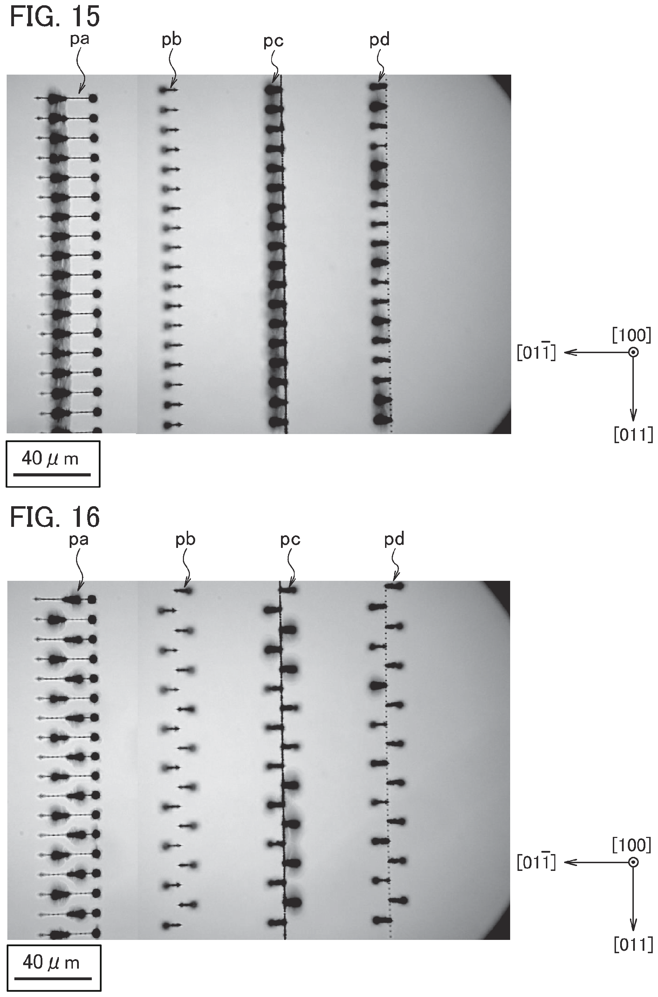

FIG. 15 is a photograph showing processing marks on the first scanning line 41a in FIG. 14. In FIG. 15, pa, pb, pc, and pd indicate processing marks when the first scanning line 41a and the second scanning line 41b were alternately formed according to the scanning method of the laser light B in FIGS. 14 A, 14B, 14C, and 14D, respectively. In FIG. 15, in pa, graphitization of the processing marks and cleavage of the first scanning line 41a and the second scanning line 41b were observed. In pb, no starting point was formed, so that graphitization of the processing marks was not observed in the valley, but graphitization is observed as the respective scanning lines extend. This is considered to occur because the formed processing marks began to act as starting points. In pc, the reference line 44 was graphitized to effectively act as a starting point, so that the first scanning line 41a and the second scanning line 41b were graphitized and cleavage is observed to progress. In pd, when the processing marks was formed at a dot pitch of 4 $\mu$m and the focusing points of the first scanning line 41a and the second scanning line 41b overlap, graphitization of the processing marks and progress of cleavage were observed.

FIG. 16 is a photograph showing processing marks when the first scanning line 41a was formed according to the scanning method of the laser light B shown in FIG. 14. In FIG. 16, in pa, it was observed that the graphitization of the first scanning line and the state in which a wall gap developed along the crystal face of the first crystal face 11a. In pb, no starting point was formed, and the graphitization and cleavage of the first scanning line were rarely observed. In pc, it was observed that the graphitization and cleavage of the first scanning line 41a developed along the crystal face of the first crystal face 11a. In pd, it was observed that the graphitization and cleavage of the first scanning line 41a are not uniform nor sufficient. According to the results of this experiment, it is confirmed that the starting point obtained by prior processing is effective for generation of graphitization of processing marks and cleavages spreading from the scanning line in the processing of the scanning line.

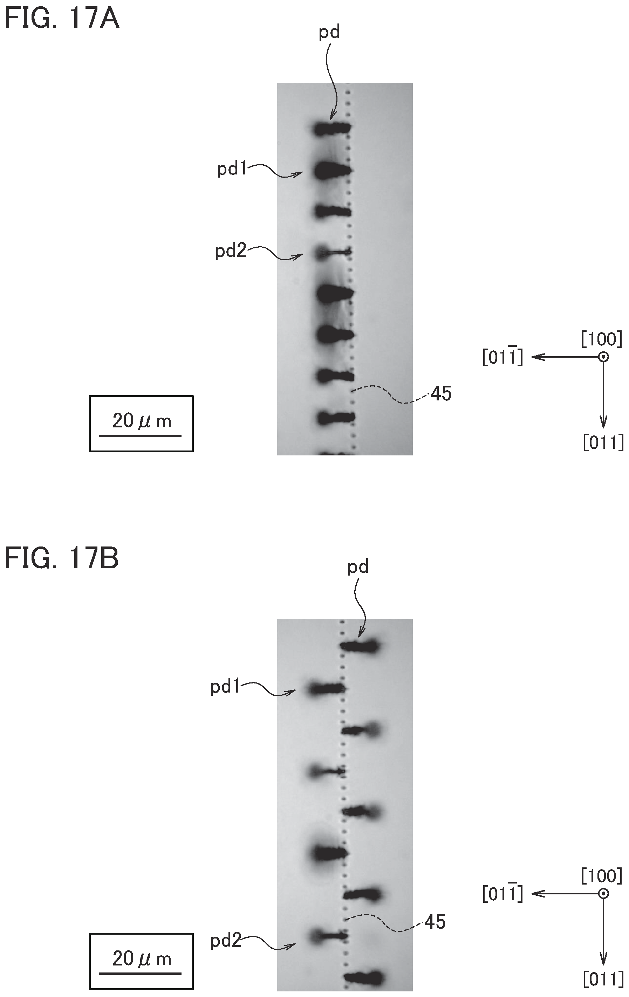

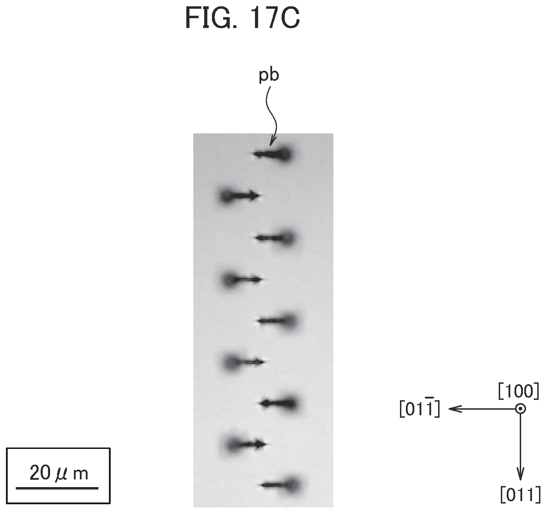

FIG. 17 is a photograph for comparing effects of the starting point by the processing mark obtained by prior processing according to the scanning method of the laser light B in FIG. 14. In FIG. 17A, the first scanning line 41 was formed from the reference line 45 in which the starting point by the processing mark was formed at a dot pitch of 4 $\mu$m as shown in FIG. 14D. Although graphitization and cleavage were observed in the first scanning line 41a of pd1 formed from the starting point, sufficient graphitization or cleavage was not observed in the first scanning line 41a of pd2 formed between the starting points. In FIG. 17B, as in FIG. 17A, the first scanning line 41a and the second scanning line 41b were formed from a reference line 45 formed with a starting point by a processing mark at a dot pitch of 4 $\mu$m as in FIG. 14D. As in FIG. 17A, graphitization and cleavage were observed in the first scanning line 41a and the second scanning line 41b of pd1 formed from the starting point, but neither sufficient graphitization nor cleavage was observed in the first scanning line 41a and the second scanning line 41b of pd2 formed between the starting points. In FIG. 17C, the first scanning line 41a and the second scanning line 41b were formed from a reference line without a processing mark as in FIG. 14B. Neither sufficient graphitization nor cleavage was observed in the first scanning line 41a and the second scanning line 41b. According to the experimental results of FIGS. 17A to 17C, it was clarified that sufficient graphitization and cleavage could be obtained when the scanning line was formed from the starting point of the processing mark, but sufficient graphitization or cleavage could not be obtained when the scanning line was not formed from the starting point of the processing mark.

(Comparative Example)

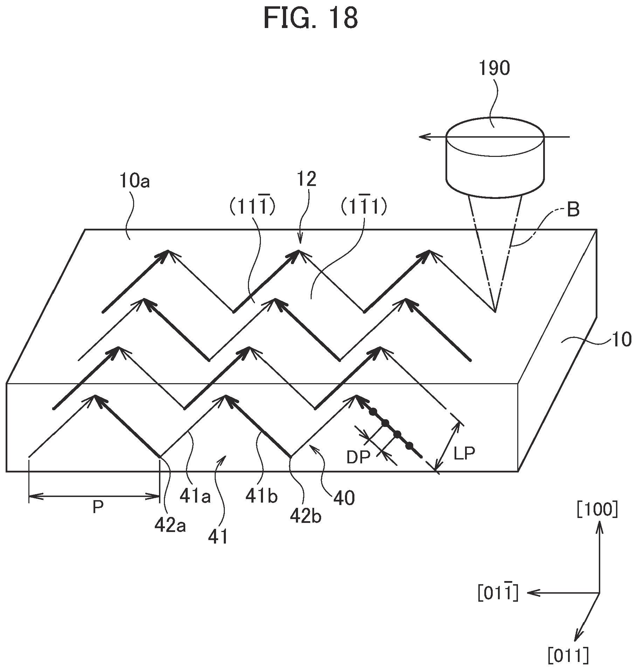

As a comparative example, a method of scanning the laser light B without prior processing for the first starting point 42a and the second starting point 42b will be described. FIG. 18 is a schematic diagram illustrating a method of scanning the laser light B as a comparative example. In the comparative example, the first starting point 42a and the second starting point 42b were not formed using processing marks, and the first prior scanning line 43a and the second prior scanning line 43b starting from the first starting point 42a and the second starting point 42b were not formed. The comparative example is the same as the laser light B scanning method of the embodiment except that no prior processing is performed.

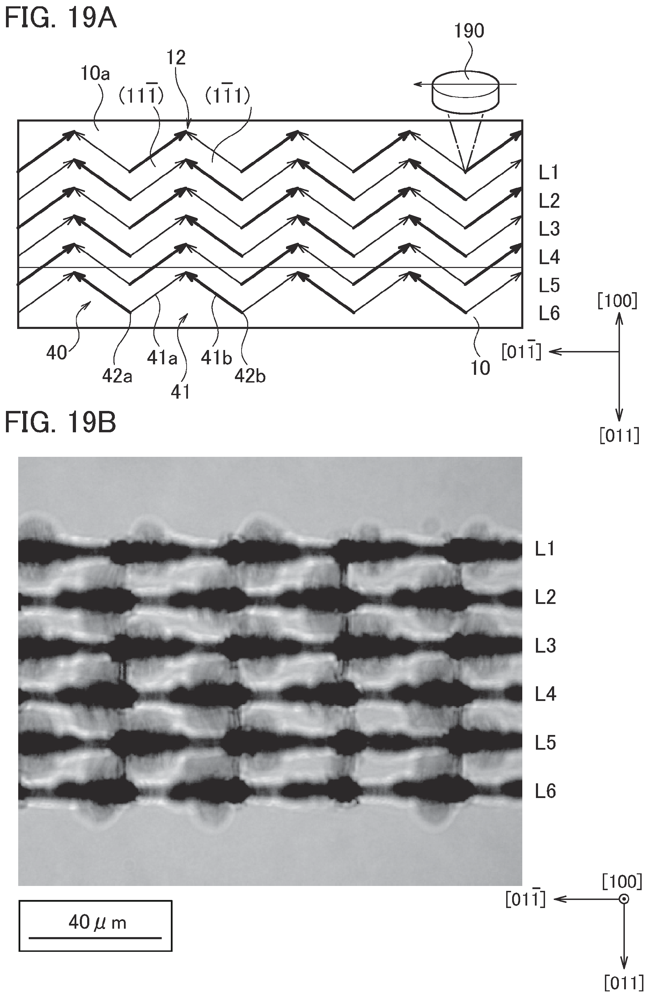

FIG. 19 is a diagram illustrating the scanning line 40 formed in the single crystal diamond block 10 in the scanning method of the laser light B according to the comparative example. FIG. 19A is a schematic diagram of the scanning line 40 formed in the block 10. FIG. 19B is a photograph of the scanning line 40 formed in the block 10 in accordance with FIG. 19A. The scanning line 40 includes the first scanning line 41a and the second scanning line 41b.

Processing conditions are shown in Table 4. In FIG. 19A, the laser light B was scanning in the direction indicated by arrows, and the first scanning line 41a indicated by thin line arrows was formed before the second scanning line 41b indicated by thick line arrows. As an example, the second scanning line 41b of the (11-1) surface was formed after the first scanning line 41a of the (1-11) surface was formed in L1. The scanning line 40 is formed at H = 15 $\mu$m from the second depth D2 described above. In the photograph of 19B, in the scanning line unit 41 constituting the scanning line 40, graphite and cleavage spreading around the second scanning line 41b processed later were observed. However, the progress of graphitization and cleavage was insufficient in the first scanning line 41a processed earlier. This is because the processing mark existed at the starting point at the second depth D2 of the second scanning line 41b processed later, while the processing mark did not exist at the starting point of the first scanning line 41a processed earlier.

[Table 4]

| Machining Conditions | | Scanning Line |
|---|---|---|
| Wavelength | nm | 1030 |
| Pulse Width | ps | 10 |
| Transmission Frequency | kHz | 0.1 |
| Pulse Energy | $\mu$J | 1.5 |
| Dot Pitch | $\mu$m | 2 |
| Line Pitch | $\mu$m | 15 |
| Height (H) | $\mu$m | 15 |
| Number of Lines | Line | 6 |

The embodiments and experiments have been described above. However, these embodiments and experiments are merely examples for embodying the technical concept of the present invention, and the scope of the invention is not intended to be limited thereto. The embodiments may be possible in various other forms, and various omissions, substitutions, and changes may be made without departing from the gist of the invention. This application claims priority under Japanese Patent Application No. 2023-121832, filed July 26, 2023, and the entire contents of which are hereby incorporated by reference.

REFERENCE SIGNS LIST

| | |
|---|---|
| 10 | Block |
| 10a | Main Surface |
| 40 | Scanning line |
| 41 | Scanning line unit |
| 41 | First scanning line |
| 41b | Second scanning line |
| 42a | First starting point |
| 42b | Second starting point |
| 43a | First prior scanning line |
| 43b | Second prior scanning line |
| 44, 45 | Reference line |
| 100 | Processing device |
| 190 | Laser condenser |

**Claims**

1. A method of manufacturing a diamond substrate comprising:

   a step of arranging a laser condenser configured to condense laser light, to face a {100} plane of a single crystal diamond block, which is a main surface;
   a step of performing prior processing on a first starting point and a second starting point respectively set on a first crystal face and a second crystal face from among crystal faces constituting a {111} plane, by condensing the laser light using the laser condenser, the first crystal face and the second crystal face forming a wedge structure whose tip becomes thinner toward the main surface inside the single crystal diamond block; and
   a step of forming a scanning line unit by condensing the laser light using the laser condenser, and forming a first scanning line and a second scanning line on the first crystal face and the second crystal face, respectively, using processing marks from the first starting point and the second starting point toward the main surface, the first scanning line and the second scanning line being connected at the tip of the wedge structure.

2. The method of manufacturing a diamond substrate according to claim 1, wherein forming the first scanning line and the second scanning line includes forming a modified layer including processing marks obtained by pyrolyzing diamond into graphite, and cleavage of the {111} plane around the processing marks.

3. The method of manufacturing a diamond substrate according to claim 1 or 2, wherein the prior processing is processing of forming processing marks on the first starting point and the second starting point.

4. The method of manufacturing a diamond substrate according to claim 1 or 2, wherein the prior processing is processing of forming a first prior scanning line and a second prior scanning line on the first crystal face and the second crystal face, respectively, using processing marks from the first starting point and the second starting point to the tip of the wedge structure.

5. The method of manufacturing a diamond substrate according to claim 1 or 2, wherein the first starting point and the second starting point are formed at the same depth from the main surface.

6. The method of manufacturing a diamond substrate according to claim 5, wherein the scanning line unit is formed by an isosceles triangle having a line segment connecting the first starting point and the second starting point as the bottom, and the first scanning line and the second scanning line as sides.

7. The method of manufacturing a diamond substrate according to claim 1, further comprising:

   a step of performing another prior processing, for another first crystal face and another second crystal face, on another first starting point set on the other first crystal face, the other first starting point obtained by redesignating the second starting point, and another second starting point set on the other second crystal face, by condensing the laser light using the laser condenser, the other first crystal face and the other second crystal face being parallel to the first crystal face and the second crystal face, respectively, and forming another wedge structure whose tip becomes thinner toward the main surface inside the single crystal diamond block; and

a step of forming another scanning line unit by condensing the laser light using the laser condenser, and forming another first scanning line and another second scanning line on the another first crystal face and the another second crystal face, respectively, using processing marks from the another first starting point and the another second starting point toward the main surface, the another first scanning line and the another second scanning line being connected at the tip of the other wedge structure.

8. The method of manufacturing a diamond substrate according to claim 7, wherein the step of forming the other first scanning line and the other second scanning line includes a step of forming a modified layer including processing marks obtained by pyrolyzing diamond into graphite, and cleavage of {111} planes around the processing marks.

9. The method of manufacturing a diamond substrate according to claim 7 or 8, wherein the other prior processing is processing of forming processing marks on the other first starting point and the other second starting point.

10. The method of manufacturing a diamond substrate according to claim 7 or 8, wherein the other prior processing is processing of forming another first prior scanning line and another second prior scanning line on the other first crystal face and the other second crystal face, respectively, using processing marks from the other first starting point and the other second starting point to the tip of the other wedge structure.

11. The method of manufacturing a diamond substrate according to claim 7 or 8, further comprising a step of redesignating the other scanning line unit as the scanning line unit.

12. The method of manufacturing a diamond substrate according to claim 7 or 8, further comprising: a step of forming a scanning line by successively adding the scanning line unit through repeating:

a step of redesignating the other scanning line unit as the scanning line unit;
a step of redesignating the second starting point as the other first starting point and forming the other second starting point; and
a step of configuring the other scanning line unit by forming the other first scanning line and the other second scanning line from the other first starting point and the other second starting point, respectively.

13. The method of manufacturing a diamond substrate according to claim 12, further comprising: a step of forming a plurality of scanning lines in parallel to each other inside the single crystal diamond block.

14. The method of manufacturing a diamond substrate according to claim 13, wherein the first scanning line and the second scanning line, which constitute the scanning line unit of the scanning line, are formed on a common crystal face with the first scanning line and the second scanning line, which constitute an adjacent scanning line unit.

15. The method of manufacturing a diamond substrate according to claim 14, wherein graphitized processing marks and the cleavage generated therearound on the {111} plane of the modified layer formed on each scanning line develops between adjacent scanning lines, thereby forming the modified layer, which extends along the {100} plane parallel to the main surface.

16. The method of manufacturing a diamond substrate according to claim 15, further comprising: a step of dividing the single crystal diamond block along the cleavage of the {111} plane developed between the processing marks in the modified layer.

# FIG. 1

# FIG. 2A

$[01\bar{1}] \leftarrow$ $[100]$

$[011]$

{111}  (111)

10

10a

$[01\bar{1}] \leftarrow$ ⫪ B

$(1\bar{1}1)$  $(11\bar{1})$

⫪ B

$[01\bar{1}]$

$(1\bar{1}\bar{1})$

(100)

$[011]$

# FIG. 2B

{111}  (111)

10a

10

55°

(100)

$[100]$

$[01\bar{1}] \leftarrow$

$[011]$

17

# FIG. 3A

$[2\bar{1}\bar{1}]$
{111}   (111)

$[21\bar{1}]$                    $(11\bar{1})$

$[01\bar{1}]$   ⫿⫿   IIIB        IIIB   ⫿⫿

$(1\bar{1}1)$                    $[2\bar{1}1]$

$[211]$
$(1\bar{1}\bar{1})$

10
10a

(100)

$[01\bar{1}]$   ←   ⊙   $[100]$
$[011]$

$[011]$

# FIG. 3B

$\langle 211 \rangle$   {111}   $\langle 211 \rangle$
(111)

10a

55°

10

(100)

$[100]$
$[01\bar{1}]$   ←   ⊙
$[011]$

# FIG. 4

# FIG. 5A

# FIG. 5B

# FIG. 5C

# FIG. 5D

FIG. 6A

FIG. 6B

FIG. 6C

FIG. 6D

# FIG. 7

# FIG. 8

FIG. 9A

FIG. 9B

100 μm

FIG. 9C

100 μm

FIG. 10A

FIG. 10B

# FIG. 11

L1

L2

L3

L4

L5

L6

40 $\mu$ m

[100]

[01$\bar{1}$]

[011]

FIG. 12A

350 $\mu$ m

LP15 $\mu$ m

[100]

[01$\bar{1}$]

[011]

FIG. 12B

350 $\mu$ m

LP20 $\mu$ m

[100]

[01$\bar{1}$]

[011]

## FIG. 13A

LOWER SURFACE

[100]
[01 $\bar{1}$ ] ←

[011]

350 $\mu$ m

## FIG. 13B

UPPER SURFACE

[011]

[01 $\bar{1}$ ] ←
[100]

350 $\mu$ m

FIG. 14A

FIG. 14B

FIG. 14C

FIG. 14D

# FIG. 15

pa pb pc pd

40 μm

[100]
[01̄1̄] ←
[011]

# FIG. 16

pa pb pc pd

40 μm

[100]
[01̄1̄] ←
[011]

FIG. 17A

FIG. 17B

# FIG. 17C

pb

20 μm

[100]

[01$\bar{1}$]

[011]

# FIG. 18

## FIG. 19A

## FIG. 19B

40 μ m

## INTERNATIONAL SEARCH REPORT

| International application No. |
|---|
| **PCT/JP2024/025892** |

### A. CLASSIFICATION OF SUBJECT MATTER

*C30B 29/04*(2006.01)i; *C01B 32/28*(2017.01)i; *C30B 33/04*(2006.01)i
FI:   C30B29/04 V; C30B33/04; C01B32/28

According to International Patent Classification (IPC) or to both national classification and IPC

### B. FIELDS SEARCHED

Minimum documentation searched (classification system followed by classification symbols)

C30B29/04; C01B32/28; C30B33/04; H01L21/304; B23K26/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2023-29250 A (UNIV. SAITAMA) 03 March 2023 (2023-03-03)<br>entire text, all drawings | 1-16 |
| A | JP 2020-50563 A (DISCO ABRASIVE SYSTEMS LTD.) 02 April 2020 (2020-04-02)<br>entire text, all drawings | 1-16 |
| P, A | JP 2024-38855 A (UNIV. SAITAMA) 21 March 2024 (2024-03-21)<br>entire text, all drawings | 1-16 |

☐ Further documents are listed in the continuation of Box C.          ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **21 August 2024** | **03 September 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

## INTERNATIONAL SEARCH REPORT
### Information on patent family members

International application No.

**PCT/JP2024/025892**

| Patent document cited in search report | | | Publication date (day/month/year) | Patent family member(s) | | | Publication date (day/month/year) |
|---|---|---|---|---|---|---|---|
| JP | 2023-29250 | A | 03 March 2023 | (Family: none) | | | |
| JP | 2020-50563 | A | 02 April 2020 | US | 2020/0105543 | A1 | |
| | | | | KR | 10-2020-0036731 | A | |
| | | | | TW | 202013473 | A | |
| | | | | CN | 110961803 | A | |
| JP | 2024-38855 | A | 21 March 2024 | (Family: none) | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2015059069 A
- JP 2020050563 A
- JP 2023121832 A